# EUROPÄISCHE PATENTSCHRIFT

(11) **EP 2 814 708 B1**
(45) Veröffentlichungstag und Bekanntmachung des Hinweises auf die Patenterteilung: **15.01.2020**
(21) Anmeldenummer: 12740545.4
(22) Anmeldetag: 18.07.2012
(51) Int. Cl.: B60T 11/16, G01D 5/14, B60Q 1/44, B60T 7/04, H01H 36/00

(54) **HAUPTBREMSZYLINDER MIT EINER VORRICHTUNG ZUR BERÜHRUNGSLOSEN ÜBERWACHUNG VON POSITION UND BEWEGUNG EINES LINEAR BEWEGBAREN KOLBENS**
MAIN BRAKE CYLINDER HAVING A DEVICE FOR THE CONTACTLESS MONITORING OF THE POSITION AND MOVEMENT OF A LINEARLY MOVABLE PISTON
MAÎTRE-CYLINDRE DE FREIN COMPRENANT UN DISPOSITIF PERMETTANT UNE SURVEILLANCE SANS CONTACT DE LA POSITION ET DU DÉPLACEMENT D'UN PISTON LINÉAIREMENT MOBILE

(30) Priorität: 14.02.2012 DE 102012202198
(43) Veröffentlichungstag der Anmeldung: 24.12.2014
(73) Patentinhaber: Continental Teves AG & Co. OHG, 60488 Frankfurt am Main (DE)
(72) Erfinder: VOIGTMANN, Thomas, 07952 Pausa (DE); SIMON, Dirk, 63533 Mainhausen (DE); KNEWITZ, Ingo, 61267 Neu Anspach (DE)
(86) Internationale Anmeldenummer: PCT/EP2012/064041
(87) Internationale Veröffentlichungsnummer: WO 2013/120544

(56) Entgegenhaltungen:
- US-A1- 2004 164 611

## Beschreibung

Die Erfindung betrifft einen Hauptbremszylinder mit den Merkmalen vom Oberbegriff vom Patentanspruch 1. Hauptbremszylinder mit einer berührungslosen Erfassung sind grundsätzlich bekannt.

### Stand der Technik:

Beispielsweise beschreibt die DE 10 2004 014 808 A1 einen Hauptbremszylinder wobei ein Magnet als Geberelement mittels Federmitteln zwischen zwei Kolben in einer Bohrung vom Gehäuse angeordnet und relativ zu wenigstens einem der Kolben verschiebbar vorgesehen ist. Zur Führung des Magneten weist ein Kolben einen zapfenartigen Kolbenabschnitt auf, auf welchem ein Träger für den Magneten federnd vorgespannt angeordnet ist. Aus US 2004/164611 A1 ist eine andere Vorrichtung bekannt; wobei in dem Kolben ein rotationssymmetrisches Magnetteil und im Gehäuse eine Erfassungseinheit angeordnet sind. Die Erfassungseinheit weist dabei einen komplexen Aufbau mit einem Magneten, einem Magnetdetektor und mehreren "L"-förmig geformten Polschuhen. Derartige Anordnungen verlangen jedoch nach einer relativ aufwändigen Konstruktion mit zusätzlichen Bauteilen und widerspechen einem regelmäßigen Wunsch nach einer Verkleinerung der Abmessungen.

### Aufgabe:

Es ist daher eine Aufgabe der vorliegenden Erfindung, die Funktionspräzision weiter zu erhöhen, Herstellaufwand, Bauteilanzahl und Kosten bei reduzierter Baulänge zu verringern und Kalibriermöglichkeiten zu verbessern.

Hierbei sei angemerkt, dass Aufbau und Wirkungsweise von konventionellen Hauptzylindern sowie ihre Rolle in einem Bremssystem in der Literatur hinreichend beschrieben worden sind (siehe beispielsweise Bremsen-Handbuch, ISBN -3-528-03952), daher wird nachfolgend lediglich auf die im Zusammenhang mit der vorliegenden Erfindung stehenden Merkmale und Funktionen eingegangen.

### Lösung:

Die Aufgabe wird erfindungsgemäß zusammen mit den kennzeichnenden Merkmalen von dem unabhängigen Anspruch 1 gelöst. Unteransprüche geben weitere mögliche vorteilhafte Ausgestaltungen an.

### Vorteile:

Zur Lösung der Aufgabe wird eine Vorrichtung zur berührungslosen Überwachung eines Kolbens eines erfindungsgemäßen Hauptbremszylinders vorgeschlagen worin eine am Gehäuse des Hauptbremszylinders ortsfest angeordnete Sensoreinheit ein Magnetfeld in Richtung Kolben aussendet und dem Kolben ein Joch zugeordnet wird, welches einen magnetischen Kreis schließt und das in der Sensoreinheit erzeugte Magnetfeld derart beeinflusst und verändert bzw. verzerrt, dass diese Veränderung durch die Sensoreinheit erfasst werden kann. Eine momentane Position und dadurch auch eine Bewegung des Jochs sind dadurch von der Sensoreinheit besonders einfach und exakt erfassbar.

Das benötigte Magnetfeld kann besonders einfach durch einen Permanentmagneten innerhalb der Sensoreinheit erzeugt werden. Der Permanentmagnet kann dabei vorzugsweise aus einem günstigen kunststoffgebundenen Hartferrit und ohne seltene Erden im Spritzverfahren herstellbar sein. Der Permanentmagnet kann dadurch vorteilhafterweise vergleichbar einfach, kostengünstig und in nahezu beliebiger Formenvielfalt hergestellt werden.

Die Sensoreinheit kann besonders einfach außen am Gehäuse des Hauptbremszylinders angeordnet vorgesehen sein, beispielsweise in einer geeigneten Sacklochbohrung oder einer andersartigen Ausnehmung oder Befestigungseinrichtung, was einen einfachen Zugriff, vielfältige Gestaltungs- und Anschlussmöglichkeiten und unkomplizierte Austauschbarkeit im Schadensfall garantiert.

Die erfindungsgemäße Vorrichtung ist vorteilhafterweise nicht auf einen bewegbaren Magneten angewiesen, so dass der Hauptbremszylinder besonders einfach und kompakt gestaltet werden kann. Auch wird eine Gefahr von Ansammlung magnetischer Partikeln innerhalb des Hauptbremszylinders erheblich reduziert wird und dadurch kann ein positiver Effekt auf eine Lebensdauer von beispielsweise Dichtelementen erzielt werden. Ferner sind deutlich geringere Feldstärken für eine zuverlässige Sensierung erforderlich, dadurch wird ein größerer Luftspalt bzw. Abstand zwischen dem Joch und Sensoreinheit ermöglicht, eine geringere Messabweichung ist erreichbar. Durch eine Verwendung von einem stärkeren Magnetfeld ist bei einem gegenüber dem Stand der Technik immer noch geringeren Materialeinsatz besonders große Luftspalte oder Messreichweiten realisierbar.

Besonders vorteilhaft ist, wenn das benötigte Magnetfeld durch ein in der Sensoreinheit angeordnetes Magnetelement erzeugt wird. Besonders effizient kann das Magnetelement derart ausgebildet werden, dass es einteilig gestaltet ist, einen Grundkörper und wenigstens drei Vorsprünge aufweist, wobei die Vorsprünge sich vom Grundkörper aus weitgehend in Richtung Kolbenachse erstrecken und an ihren der Kolbenachse zugewandten Enden gleichwertige Magnetpole ausbilden, dessen Magnetfelder sich gegenseitig abstoßen.

Besonders vorteilhaft ist, wenn wenigstens eines der Vorsprünge kürzer ausgebildet ist als wenigstens zwei weitere Vorsprünge. Durch mindestens drei solche vorstehend beschriebenen Magnetpole wird ein Raumabschnitt mit begrenzt, in dem ein lokales Minimum einer magnetischen Flussdichte mit B=0mT oder B≈0mT vorhanden ist.

Mit Vorteil kann in dem Raumabschnitt zwischen den Magnetpolen wenigstens ein magnetosensitives Element derart angeordnet werden, dass das vorstehend beschriebene lokale Minimum der magnetischen Flussdichte innerhalb des magnetosensitiven Elements vorliegt. Hierdurch kann beispielsweise das magnetosensitive Element besonders empfindlich auf Veränderungen der magnetischen Flussdichte reagieren.

Ferner werden eine besonders einfache, robuste und kostengünstige Konstruktion der Sensoreinheit und Aufbau der Vorrichtung möglich. Dabei können vergleichsweise günstige Werkstoffe wie insbesondere kunstoffgebundener Hartferrit und effiziente Herstellverfahren wie beispielsweise Spritzverfahren zur Herstellung vom Magnetelement eingesetzt werden, um eine für eine sichere Messung ausreichende Magnetfeldstärke und Magnetflussdichte zu erreichen. Auf vergleichbar teurere Seltene Erden kann verzichtet werden.

Vorteilhafterweise ist der Kolben, dessen Position und Bewegung überwacht werden, aus einem nicht magnetisierbaren Material, insbesondere Kunststoffwerkstoff, gestaltbar. Dadurch sind beispielsweise signifikante Vorteile bei Kosten, Gewicht und Gestaltungsmöglichkeiten erzielbar. Selbstverständlich kann der Kolben aber auch als Metallkolben aus einem nicht- oder im Wesentlichen nicht magnetisierbaren Werkstoff oder in Mischbauweise hergestellt werden.

Die vorstehend beschriebene Vorrichtung ermöglicht ferner eine vorteilhafte gewichts- und kostenreduzierende Gestaltung vom Hauptbremszylinder aus nicht magnetisierbaren Werkstoffen beispielsweise einem Aluminium- oder einem Kunststoffwerkstoff.

In einer vorteilhaften Weiterbildung der Erfindung ist das Joch unmittelbar an dem Kolben angeordnet vorgesehen, wobei auch eine mittelbare Anordnung mit weiteren Zwischenelementen möglich ist. Hierbei kann das Joch sowohl direkt am Kolben als auch an einer zusätzlichen Ausformung des Kolbens, beispielsweise einem Zapfen, abgestützt oder fixiert vorgesehen sein.

Besonders vorteilhaft ist jedoch, wenn der Kolben eine Ausnehmung zur Aufnahme vom Joch aufweist, in welche das Joch einfügbar sein kann, beispielsweise eine Nut, oder welche bei einer Herstellung des Kolbens unmittelbar um das Joch herum direkt entsteht, beispielsweise bei einer Umspritzung vom Joch durch Kolbenwerkstoff.

In einer besonders vorteilhaften Ausführungsform der Erfindung kann das Joch ringförmig und somit unempfindlich gegen eine Radialverdrehung eines Kolbens ausgebildet sein.

Durch eine oder mehrere vorstehend beschriebenen Merkmalkombinationen kann mit Vorteil eine Art Baukastensystem realisiert und dadurch ein größerer Umfang von möglichen Ausführungen durch vergleichbar wenige Standardelemente abgedeckt werden.

Dies ermöglicht zudem eine besonders kostengünstige Herstellbarkeit und eine einfache Verbindbarkeit von Joch und Kolben. So kann das Joch beispielsweise in eine innen oder außen am Kolben angeordnete umlaufende Nut eingebracht, am Kolben verschraubt, geklebt, gesteckt, mit einem Sprengring gesichert oder auf eine andere Weise auf dem Kolben befestigt sein. Des Weiteren wäre eine Befestigung des Jochs auf einem zusätzlichen, mit dem Kolben gekoppelten und mit diesem synchron bewegbaren Element denkbar.

In einer besonders vorteilhaften Weiterbildung der Erfindung kann das Joch an seinem Außenumfang vom Kolbenwerkstoff derart vollständig oder teilweise bedeckt gestaltet werden, dass vorteilhafterweise eine störungsfreie glatte Oberfläche der Außenwandung des Kolbens ohne störende Elemente realisierbar wird, was beispielsweise eine Gefahr einer Ansammlung von Schmutzpartikel im Bereich des Jochs deutlich reduziert und durch ein Dichtelement ohne Nachteile einem möglichen Dichtlippenschädigung überfahrbar macht.

Selbstverständlich sind jedoch auch weitere Formen des Jochs aber auch weitere Materialien und Anbindungsarten realisierbar, ohne die Erfindung zu verlassen, beispielsweise als ein Segmentelement, ein zylindrisches oder eckiges Einsatzelement etc., denkbar.

In einer vorteilhaften Ausführungsform kann das Joch aus einem einfachen vergleichsweise günstigen Stahlwerkstoff, insbesondere Automatenstahl gefertigt werden und ist somit deutlich günstiger als beispielsweise ein Geberelement aus einem Magnetwerkstoff, herstellbar sein. Es sind jedoch vorteilhafterweise prinzipiell beliebige Werkstoffe, die ein Magnetfeld leiten können, zur Herstellung vom Joch geeignet.

Durch eine Verschiebung des Jochs im Magnetfeld und entlang einer Verschiebungsachse des Kolbens wird das Magnetfeld insbesondere in eine zur Verschiebungsachse des Kolbens im Wesentlichen senkrechte, radiale Richtung verändert beziehungsweise verzerrt. Diese Veränderung kann vorteilhafterweise durch die ortsfeste Sensoreinheit besonders exakt und sicher erfassbar sein, insbesondere als eine lokale Veränderung einer magnetischen Flussdichte.

Zur Erfassung der Veränderung des Magnetfeldes verfügt die Sensoreinheit über ein oder mehrere magnetosensitiven Elemente.

Mit Vorteil kann als ein magnetosensitives Element ein relativ günstiges Hall-Element eingesetzt werden, obwohl natürlich auch ein anderer Typ verwendbar ist. Ein Hall-Element weist im Prinzip einen stromdurchflossenen Festkörper auf, meist als ein dünnes Halbleiterplättchen oder -streifen ausführbar. Wird dieser Festkörper in einen Magnetfeld gebracht, der senkrecht zum Stromfluss angeordnet ist, werden die Elektronen im Festkörper durch die Lorentz-Kraft senkrecht zum Magnetfeld abgelenkt. Durch diese Verschiebung der Ladung wird eine Spannung erzeugt, die proportional zum Produkt aus magnetischer Feldstärke und Strom ist, sogenannte Hall-Spannung. Die Höhe der Spannung gibt Auskunft über die Stärke des Magnetfeldes oder seiner Veränderung. Dieser Effekt wird letztendlich zum Detektieren von Position und Bewegungen von Körpern eingesetzt, welche das Magnetfeld beeinflussen können. Die Richtung der Lorenzkraft und des Stromflusses bilden eine Ebene, welche als sensitive Ebene eines Hall-Sensors bezeichnet werden kann. Ein Hall-Sensor wird meist so angeordnet, dass die sensitive Ebene möglichst senkrecht zur Ausrichtung eines zu messenden Magnetfeldes ausgerichtet ist. Andere magnetosensitiven Elemente oder Sensoren verfügen meist ebenso über eine sensitive Ebene, welche senkrecht zum Magnetfeld ausgerichtet werden soll, um einen optimalen Messeffekt zu erreichen. In einer vorteilhaften Weiterbildung der Erfindung kann das Magnetosensitive Element in der Sensoreinheit und relativ zum Magnetfeld derart angeordnet sein, dass in unmittelbarer Nähe des magnetosensitiven Elements ein lokales Minimum der Flussdichte eines Magnetfeldes mit idealerweise 0mT vorliegt. Dadurch kann ein besonders robustes und genaues Messergebnis erzielt werden, weil beispielsweise bereits kleine Verzerrungen des Magnetfeldes durch das Joch eine deutliche Änderung einer Flussdichte innerhalb des magnetosensitiven Elements hervorrufen können. Durch eine besonders hohe Effizienz einer solchen Anordnung können zudem vorteilhafterweise größere Luftspalte realisiert und/oder günstigere magnetosensitiven Elemente mit geringerer Empfindlichkeit eingesetzt werden, als aus dem Stand der Technik für ein vergleichbares Einsatzgebiet erforderlichen. So können vorteilhafterweise Bewegungen des Jochs unter 1mm Wegstrecke eindeutig zweifelsfrei registriert und somit als ein Schaltpunkt definiert werden. Eine solche Wegstrecke ist, bezogen auf die meisten bekannten Hauptzylinder, geringer als ein Schließweg eines Kolbens, d.h. ein Weg, welchen der Kolben zurücklegt, bis eine Druckausgleichsverbindung zwischen einer Druckkammer und einem Druckmittelbehälter unterbrochen wird und es zu einem Druckaufbau in einem Bremskreis erst kommt. Dadurch kann beispielsweise ein besonders wichtiger Zeitvorteil bei einem kritischen Bremsmanöver gewonnen werden um beispielsweise einen notwendigen Regelvorgang oder eine weitere Aktion einzuleiten.

Vorteilhafterweise können innerhalb der Erfindung sowohl analoge Hall-Elemente oder andere Elemente, beispielsweise zum kontinuierlichen Detektieren von Wegen oder Wegstrecken als auch digitale Hall-Sensoren oder andere Elemente im Sinne von Anwesenheitsindikatoren, auch in Kombination untereinander, eingesetzt werden. Somit können Sensoreinheiten für vielfältige Einsatzbereiche und Anforderungen angeboten werden aber auch einfach oder mehrfach redundante Sensoreinheiten für eine erhöhte Ausfallsicherheit oder präzisere Messergebnisse.

Ebenso ist es möglich, die sensitiven Ebenen der magnetosensitiven Elemente sowohl parallel als auch quer zur einer Bewegungsachse des Kolbens bzw. des Jochs ausrichtbar vorzusehen um beispielsweise bestimmten Raumverhältnissen oder Anforderungen an Formgebung einer Sensoreinheit oder aber weiteren Ursachen Rechnung zu tragen und dabei weiter hin ein zuverlässiges Messergebnis zu gewährleisten.

In einer Weiterbildung der Erfindung kann dem magnetosensitiven Element eine elektronische Signalverarbeitungsvorrichtung zugeordnet werden. Mit einer solchen Signalverarbeitungsvorrichtung können beispielsweise am magnetosensitiven Element erfassbaren primären elektrischen Werte in sekundäre elektrische Signale umgewandelt werden um diese nachfolgend an eine Auswerteeinheit weiterzugeben. Insbesondere kann die elektronische Signalverarbeitungsvorrichtung in der Sensoreinheit integriert vorgesehen sein, damit kann eine kompakte, einfach austauschbare Sensoreinheit mit besonders geringen elektrischen Verlusten realisiert werden. Ferner kann eine Gefahr durch externe Störquellen, beispielsweise Funkstrahlung in Hinblick auf eine elektromagnetische Verträglichkeit reduziert werden.

Besonders vorteilhaft kann das Geberelement in einem möglichst wenig durch Druckkräfte beaufschlagen Bereich eines Hauptbremszylinders angeordnet werden, so dass die Sensoreinheit besonders nahe an das Joch angebracht vorgesehen werden kann, ohne eine mögliche Beschädigung eines Gehäuses des Hauptbremszylinders durch eine dünne Wandung zwischen der Sensoreinheit außen und dem Joch innen zu begünstigen.

Vorteilhafterweise kann die Vorrichtung zur berührungslosen Überwachung von Position und Bewegung eines linear bewegbaren Kolbens, einer erfindungsgemäßen Hauptbremszylinder die Position und Bewegung dadurch registrieren, dass das Joch bei einer Kolbenbewegung in einem Raumabschnitt oberhalb des magnetosensitiven Elements in axiale Richtung verschoben wird und dabei ein durch einen Permanentmagneten erzeugtes und das magnetosensitive Element durchdringendes Magnetfeld beeinflusst, bzw. verzerrt. Eine solche Beeinflussung des Magnetfelds verursacht eine lokale Veränderung einer magnetischen Flussdichte innerhalb des magnetosensitiven Elements. Die Veränderung der Flussdichte innerhalb des magnetosensitiven Elements eine Veränderung eines erfassbaren elektrischen Wertes, beispielsweise einer Spannung hervor. Diese Änderung kann nachfolgend durch die Auswerteeinheit ausgewertet und daraus beispielsweise eine Entfernung des Jochs vom magnetosensitiven Elements errechnet oder lediglich eine Anwesenheit des Geberelements in einem durch die Sensoreinheit erfassbaren Raumabschnitt detektiert werden. Dabei werden vorteilhafterweise keine bewegten Magnetelemente benötigt ein nahezu jedes ein Magnetfeld verzerrendes Element wird detektierbar. Beispielsweise könnte man auf ein Joch als Einzelelement gänzlich verzichten und stattdessen ein geeignetes detektierbares Konstruktionselement direkt an einem Kolben aus einem geeignetem Werkstoff vorzusehen - beispielsweise einen umlaufenden Flansch oder weitere Formelemente. Vorteilhafterweise kann eine solche Anordnung derart ausgelegt sein, dass bei einer Ausgangslage des Kolbens ein höherer Wert der Flussdichte und nach einer Kolbenbewegung in Betätigungsrichtung ein niedrigerer Wert registriert wird, wobei ein Abfall der Flussdichte zwischen den beiden Punkten nahezu linear verläuft. Dadurch kann besonders einfach, präzise und zuverlässig eine jeweilige Position des Kolbens errechnet werden und eine Einfluss von Toleranzen vergleichsweise einfach erkennbar und korrigierbar.

Jedes technisches Erzeugnis ist toleranzbehaftet. Solche Toleranzen, beispielsweise Fertigungstoleranzen oder Lagetoleranzen aber auch eine Temperatur des magnetosensitiven Elements oder anderen Systemkomponenten können ein bei einer Auslegung eingeplantes Messergebnis beeinflussen und verfälschen. Auch eine Ausgangslage eines Kolbens in einem Hauptbremszylinder muss nicht immer exakt die gleiche sein, weil beispielsweise Reibkräfte an Dichtelementen und Steifigkeitsvariationen von Rückstellfedern diese beeinflussen können.

Es erscheint daher sinnvoll und vorteilhaft, eine elektronische Kalibrierung einer Vorrichtung zur berührungslosen Überwachung von Position und Bewegung eines linear bewegbaren Kolbens einmalig bei einer Inbetriebnahme oder regelmäßig vorzunehmen, um eine tatsächliche räumliche Lage der betroffenen Elemente zueinander, insbesondere einen axialen Abstand, den tatsächlich gemessenen Werten der Flussdichte zuzuordnen, beispielsweise eine tatsächliche Ausgangslage eines Kolbens im Hauptbremszylinder in einem unbetätigten Zustand einem momentanen Wert einer magnetischen Flussdichte im magnetosensitiven Element. Dieser Wert kann dann beispielsweise jedes Mal nach einem Zündungsvorgang in einem Kraftfahrzeug und somit bei jeder erneuten Aktivierung der Vorrichtung oder bei jeder erneuten Betätigung bestimmt und einer Ausgangslage zugeordnet werden Es kann jedoch bei bestimmten Anforderungen ebenso auf eine solche Maßnahme verzichtet werden oder ein toleranzausgleich auf eine andere Weise oder in einem anderem Rhythmus kompensiert werden.

Ebenso kann vorteilhafterweise vorgesehen sein, einen Einfluss von Temperatur auf eine oder mehrere Systemkomponenten oder elektrischen Signale zu berücksichtigen und temperaturbedingte Auswirkungen elektronisch zu kompensieren.

### Figurenbeschreibung:

Weitere Einzelheiten, Merkmale, Vorteile und Anwendungsmöglichkeiten der Erfindung gehen aus Unteransprüchen zusammen mit der Beschreibung anhand der Zeichnungen hervor. Gleiche Elemente und Elemente mit gleicher Funktionalität werden nach Möglichkeit mit gleichen Bezugszeichen versehen. Nachstehend zeigt:
Fig.l: eine Abbildung eines Hauptbremszylinders, ausgestattet mit einer Vorrichtung zur berührungslosen Überwachung von Position und Bewegung eines linear bewegbaren Kolbens
Fig.2: Ein Längsschnitt einer Ausführungsform eines erfindungsgemäßen Hauptbremszylinders.
Fig.3: Vereinfachte Prinzipskizze eines Hall-Elements
Fig.4: Prinzipskizze eines Zusammenwirkens eines Jochs mit einem magnetosensitiven Element und einem Magnetelement mit zwei verschiedenen Anordnungen und jeweiligen relativen Positionen (a,b,c,d).
Fig.5: Diagramm einer durch eine Sensoreinheit registrierbaren wegabhängigen magnetischen Flussdichteänderung für 3 verschiedene Kolbenpositionen.
Fig.6: Skizze zur Verdeutlichung von relevanten Lagetoleranzen.
Fig.7: Einen Magnetelement mir darin angeordneten magnetosensitiven Elementen in räumlicher Darstellung.

### Fig.1

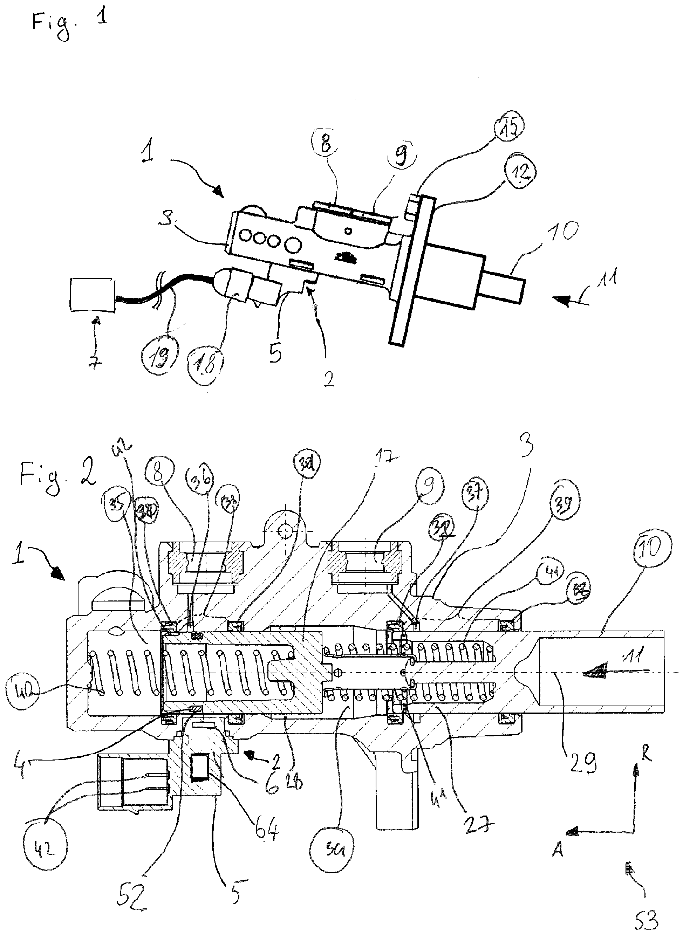

Fig.1 zeigt eine Ausführungsform eines erfindungsgemäßen Hauptbremszylinders 1, umfassend eine Vorrichtung 2 zur berührungslosen Überwachung von Position und Bewegung eines nicht gezeigten linear bewegbaren Kolbens 17. Ein Hauptbremszylinder 1 zur Erzeugung von Druck in einem daran angeschlossenen jedoch nicht gezeigten hydraulischen Bremssystem mit einer innerhalb eines Gehäuses 3 angeordneten Kolben-Feder-Anordnung ist über hydraulische Anschlüsse 8,9 an einen nicht gezeigten Druckmittelvorratsbehälter angeschlossen und verfügt über eine Druckstange 10 zur Aufnahme und Übertragung einer Betätigungskraft 11. Die Betätigungskraft 11 kann hierbei durch vielfältige krafterzeugbare, kraftverstärkende oder kraftumleitende Vorrichtungen, beispielsweise durch einen pneumatischen oder hydraulischen Bremskraftverstärker, einen Aktuator oder ein anderes vergleichbares Aggregat, oder unmittelbar durch eine Bremsbetätigungseinrichtung in die Druckstange 10 eingeleitet werden, wobei die Krafteinleitung humaninitiiert oder durch eine automatisierte Einrichtung fremdgesteuert sein kann.

Des Weiteren verfügt der hier gezeigte Hauptbremszylinder 1 über einen am Gehäuse 3 ausgebildeten Flansch 12 zur Befestigung mittels eines oder mehrerer Verbindungselemente 15 an einem Aggregat zur Einleitung der Betätigungskraft 11 oder einer Haltevorrichtung. Als Verbindungselement 15 wird meist eine reversibel lösbare Schraube oder eine Gewindebolzen-Mutter-Kombination eingesetzt.

Ferner ist die Vorrichtung 2 über eine Trennbare elektrische Verbindung 18, beispielsweise einen Stecker, und eine elektrische Leitung 19 mit einer elektronischen Auswerteeinheit 7 verbunden, wobei die Leitung 26 sowohl zur Energieversorgung der Vorrichtung 2 als auch zur Übertragung von erfassten nicht umgewandelten elektrischen Werten geeignet ist. Als Auswerteeinheit 7 kann beispielsweise ein geeignetes Steuergerät in einem Kraftfahrzeug vorgesehen sein, es ist jedoch ebenso möglich eine gesonderte in eine Sensoreinheit 5 integrierte elektronische Komponente vorzusehen, welche die erfassten elektrischen Werte umgewandelt an ein weiteres elektronisches Aggregat, weitergibt. Die durch die Vorrichtung 2 erfassten elektrischen Werte können dann beispielsweise zur Steuerung von elektronischen Regelvorgängen in einem Bremssystem, zur Steuerung von optischen und akustischen Warnvorrichtungen, zur Interpretation von humaninitiierten Bremswünschen und weiteren Zwecken eingesetzt werden.

### Fig.2

Fig.2 zeigt in Schnittdarstellung eine Ausführungsform eines erfindungsgemäßen Hauptbremszylinder 1 mit einer Vorrichtung 2 zur berührungslosen Überwachung von Position und Bewegung eines linear bewegbaren Kolbens 17. Ferner dient ein Koordinatensystem 53 mit seinen als "R" für "Radial" beziehungsweise "A für "Axial" bezeichneten Achsen zur Erklärung von fortan verwendeten Richtungsbegriffen.

Der hier dargestellte Hauptbremszylinder 1 ist ein Tandemhauptzylinder vom sogenannten Plunger-Typ. Dieser umfasst einen an einem Ende der Druckstange 10 ausgebildeten ersten Kolben 27 und einen separaten zweiten Kolben 17 zum Bremsdruckaufbau, wobei der Bremsdruckaufbau bei einer Bewegung der Kolben entlang einer Kolbenachse 29 in Richtung der Betätigungskraft 11. Die beiden Kolben sind in einem weitgehend zylindrisch ausgebildeten und mehrfach abgestuften Hohlraum 28 innerhalb des Gehäuses 3 linear verschiebbar hintereinander angeordnet. In die Wandung des Hohlraums 28 sind vier elastomeren richtungsabhängigen Dichtelemente 30-33 ortsfest eingelassen, wobei Dichtlippen der Dichtelemente 30-33 zylindrische Außenwandungen der Kolben 17,27 abstreifen. Dabei dichten die Dichtelemente 30,32 und 33 entgegen der Richtung der Betätigungskraft 11, das Dichtelement 31 in Richtung der Betätigungskraft 11 ab und können jeweils in Gegenrichtung überströmt werden. Dadurch werden ein erster Druckraum 34 und ein zweiter Druckraum 35 gebildet, die über nicht gezeigte Bremsleitungen mit jeweils einem Paar ebenfalls nicht gezeigten Radbremsen verbunden sind und so zwei getrennte Bremskreise ausbilden.

In den beiden Druckräumen 34,35 wird bei der Bewegung der Kolben der Kolben 17,27 in Richtung der Betätigungskraft 11 ein Arbeitsdruck aufgebaut. Die hydraulischen Anschlüsse 8,9 an einen nicht gezeigten unter einem Umgebungsatmosphärendruck stehenden Druckmittelvorratsbehälter sind ihrerseits über Nachlaufbohrungen 36,37 mit dem Hohlraum 28 verbunden und erlauben dadurch einen Druckmitteltransfer, wobei die Nachlaufbohrungen 36,37 jeweils in einem Bereich zwischen den Dichtelementen 30 und 31 bzw. 32 und 33 in den Hohlraum 28 münden. Dadurch herrscht auch bei einer betätigten Bremse im Bereich zwischen den Dichtelementen 30 und 31 bzw. 32 und 33 ein verglichen mit einem Druck in den Druckräumen 34,35 deutlich niedrigerer Druck, es bilden sich Niederdruckbereiche 38 bzw. 39. Im Idealfall liegt dort ein Umgebungsatmosphärendruck vor.

In einer Kolbenposition, die einer unbetätigten Bremse entspricht, besteht zwischen den Nachlaufbohrungen 36,37 und den Druckräumen 34,35 jeweils eine direkte hydraulische Verbindung, die mittels konzentrisch angeordneten Bohrungen 40 oder Einkerbungen 42 am druckraumseitigen Ende eines jeweiligen Kolbens 17,27 realisiert ist. In den beiden Druckräumen 34,35 liegt ein Umgebungsatmosphärendruck vor. Nach einem definierten Verschiebeweg der Kolben 17,27 in Richtung der Betätigungskraft 11 werden diese Verbindungen durch das Dichtelement 30 bzw. 32 abgetrennt und somit geschlossen und es beginnt ein Druckaufbau in den Druckräumen 34,35. Der vorstehend beschriebene Verschiebeweg wird als Schließweg bezeichnet.

Zur Rückstellung der Kolben 17,27 nach einer Bremsbetätigung dienen schließlich Rückstellfedern 40 bzw. 41. Eine Richtungsabhängigkeit der Dichtelemente 30-33 ermöglicht außerdem in einem unbetätigten Betriebszustand einen generellen Druckausgleich zwischen den beiden Druckräumen 34,35 und somit auch in den jeweiligen an die Druckräume 34,35 angeschlossenen Bremskreisen.

Das Ausführungsbeispiel zeigt den zweiten Kolben 17 aus einem Kunststoffwerkstoff, wobei in dem Kolben 17 eine Ausnehmung 52 vorgesehen ist und in der Ausnehmung 52 ein Joch 4 in Form eines aus einem Automatenstall gefertigten Ringes angeordnet ist. In der gezeigten Ausführungsform ist das Joch 4 vom Werkstoff des Kolbens umspritzt vorgesehen und ist von allen Seiten durch Flanken der Ausnehmung 52 umschlossen.

Es sind jedoch auch weitere Befestigungsarten möglich, ohne die Erfindung zu verlassen, so kann das Joch 4 beispielsweise nur teilweise umspritzt oder die Ausnehmung 52 kann als eine innen oder außen am Kolben 17 angeordnete umlaufende Nut vorgesehen sein, in welche das Joch 4 eingebracht ist. Des Weiteren kann das Joch 4 am Kolben verschraubt, geklebt, gesteckt, mit einem Sprengring gesichert oder auf eine andere Weise 17 befestigt sein. Ferner wäre eine Befestigung des Jochs 4 auf einem zusätzlichen, mit dem Kolben 17 oder 27 gekoppelten und mit diesem synchron bewegbaren Element denkbar. Ebenso sind sowohl weitere Ausgestaltungen des Jochs, beispielsweise als ein Segment, ein zylindrisches oder eckiges Einsatzelement etc., denkbar. Ferner sind weitere Werkstoffe, die ein Magnetfeld leiten können zur Herstellung vom Joch 4 geeignet. Ebenso sind andere im Wesentlichen nicht magnetisierbare Werkstoffe, beispielsweise Aluminium, für den Kolben 17 innerhalb der Erfindung realisierbar.

Das Joch 4 ist im Inneren des Gehäuses 3 weitgehend gegenüber einer außen am Gehäuse 3 ortsfest angeordneten Sensoreinheit 5 positioniert. Die Sensoreinheit 5 umfasst ihrerseits wenigstens ein magnetosensitives Element 6, beispielsweise ein Hall-Element und ein nicht gezeigtes Permanentmagnet zum erzeugen eines Magnetfeldes, welches durch das Joch 4 verzerrbar ist und dessen Verzerrung im magnetosensitiven Element eine Änderung eines elektrischen Wertes hervorruft und somit von der Sensoreinheit 5 erfassbar, als ein elektrisches Signal an eine nicht dargestellte elektronische Auswerteeinheit 7 übermittelbar und durch die Auswerteeinheit 7 als eine Positionsangebe des Jochs 4 interpretierbar ist. Das Joch 4 schließt somit einen in der Vorrichtung 2 vorliegenden magnetischen Kreis. Des Weiteren kann in der Sensoreinheit 5 eine elektronische Signalverarbeitungsvorrichtung 64 vorgesehen werden. Eine solche Signalverarbeitungsvorrichtung 64 kann beispielsweise zur einer Verarbeitung von am magnetosensitiven Element 6 erfassbaren primären elektrischen Werten in sekundäre elektrische Signale eingesetzt werden, wobei die sekundären elektrischen Signale an die Auswerteeinheit 7 weitergeleitet werden.

In weiteren Ausführungen und Weiterbildungen der Erfindung können auch mehrere magnetosensitiven Elemente 6 in der Sensoreinheit 5 nebeneinander angeordnet und/oder räumlich unterschiedlich ausgerichtet vorgesehen sein.

Weiterhin verfügt die Sensoreinheit 5 über mehrere Kontaktierelemente 42 zur Anbindung an eine nicht gezeigte elektrische Versorgungseinrichtung zur Versorgung des magnetosensitiven Elements 6 und eine vorstehend erwähnte elektronische Auswerteeinheit 7 zur Auswertung durch das magnetosensitive Element 6 erzeugten elektrischen Signale.

Üblicherweise werden Versorgungseinrichtung mit einer elektronischen Auswerteeinheit in einem Aggregat, beispielsweise einem Steuergerät kombiniert vorgesehen, es kann jedoch, abhängig von konkreten Einsatzerfordernissen und Typ des magnetosensitiven Elements 4 auch anders gelöst sein oder gar auf eine Versorgungseinrichtung verzichtet werden, ohne die Erfindung zu verlassen.

Bemerkenswert ist, dass das Joch 4 innerhalb des wenig durch Druckkräfte belasteten Niederdruckbereiches 38 angeordnet ist, was gefahrlos eine Realisierung einer besonders dünnen Wandung des Gehäuses 3 zwischen dem Hohlraum 28 und der Sensoreinheit 5 und somit einen besonders geringen Abstand zwischen dem Joch 4 und dem Magnetosensitiven Element 6 ermöglicht. Dies hat eine hohe Relevanz für eine resultierende Signalstärke und Reichweite einer zuverlässigen Positions- und Bewegungserfassung des Jochs 4.

Die vorstehend beschriebenen Konstruktionselemente können genauso in abgewandelten Ausführungsformen vorliegen, ohne die Erfindung zu verlassen, so können beispielsweise auch Zentralventilhauptbremszylindern oder weiteren mit Kolben und/oder Druckstangen ausgestatteten Hauptbremszylindern eine Ausführungsvorm einer Vorrichtung 2 zugeordnet werden.

### Fig.3

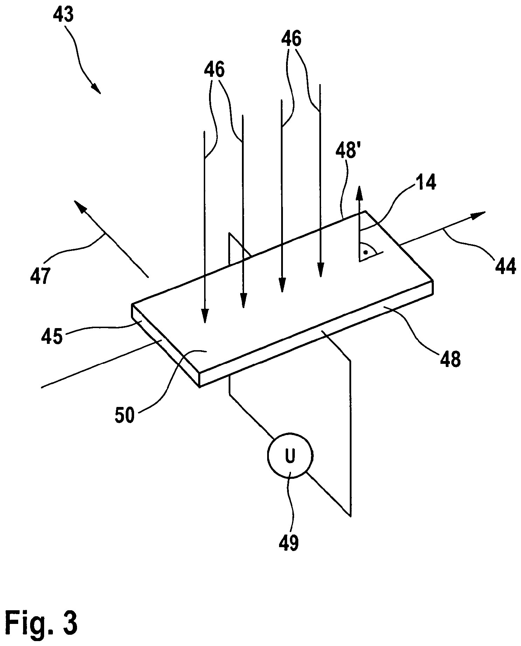

In der Fig.3 ist ein Hall-Element 43 zur Verdeutlichung seines Wirkprinzips stark vereinfacht dargestellt. Ein auf einem derartigen Hall-Element 43 aufbauender Hall-Sensor kann auch mehrere solche Hall-Elemente 43 umfassen.

Ein Hall-Element 43 weist im Prinzip einen durch einen stromdurchflossenen Festkörper 45 auf, der meist als ein dünnes Halbleiterplättchen oder -streifen ausgebildet ist. Wird der Festkörper 45 in einen durch symbolische dargestellten Magnetfeld 46 gebracht, der senkrecht zum Stromfluss 44 angeordnet ist, werden Elektronen im Festkörper 45 durch eine Lorentz-Kraft 47 senkrecht zum Magnetfeld 46 abgelenkt, es erfolgt eine Ladungsverschiebung, die zur einer elektrischen Potentialdifferenz an gegenüberliegenden Seiten 48,48' des Festkörpers 45 führt. Diese Potentialdifferenz ist als eine Spannung 49 "U", sogenannte Hall-Spannung erfassbar, wobei sie sie proportional zum Produkt aus magnetischer Feldstärke und Strom ist. Die Höhe der Spannung 49 gibt Auskunft über die Stärke des Magnetfeldes 46 oder seiner Veränderung. Dieser Effekt kann zum Detektieren von Position und Bewegungen von Körpern eingesetzt, welche das Magnetfeld 46 beeinflussen, beispielsweise seine Richtung verzerren oder seine Stärke verändern können. Die Richtung der Lorenzkraft 47 und des Stromflusses 44 bilden eine Ebene, welche als sensitive Ebene 50 bezeichnet werden kann. Um einen optimalen Messeffekt zu erreichen wird ein Hall-Element 43 meist so angeordnet, dass die sensitive Ebene 50 möglichst senkrecht zur Ausrichtung eines zu messenden Magnetfeldes 46 ausgerichtet ist, bzw. eine Normale 14 einer sensitiven ebene 50 parallel zum Magnetfeld 46 ausgerichtet ist. Andere magnetosensitiven Elemente oder Sensoren verfügen meist ebenso über eine sensitive Ebene, welche senkrecht zum Magnetfeld ausgerichtet werden sollte, um optimale Signalstärken zu erreichen.

### Fig.4

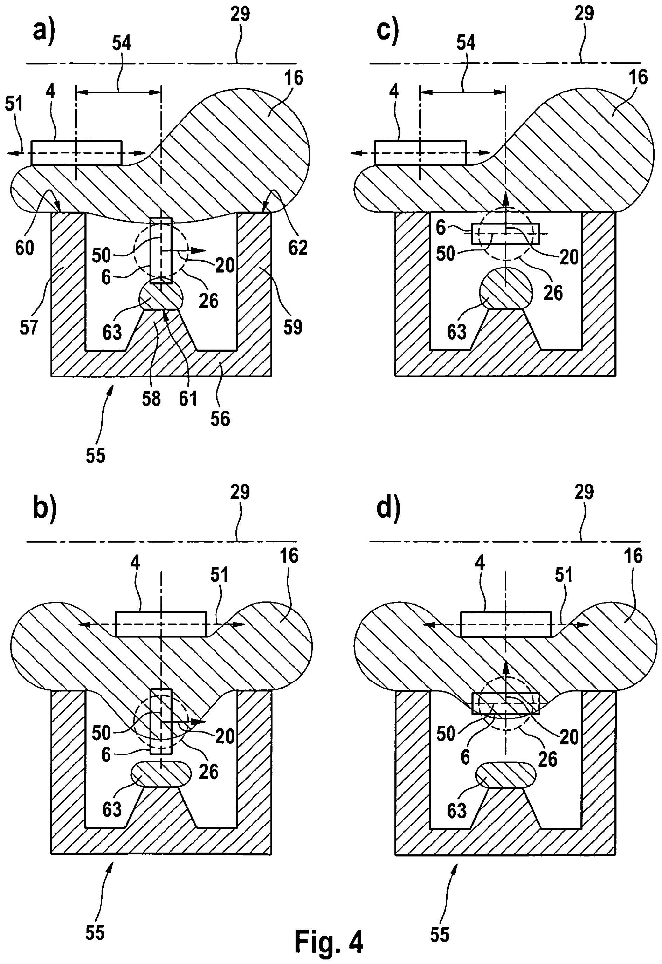

In der Fig.4a ist eine Prinzipskizze eines Zusammenwirkens eines Jochs 4 mit einem magnetosensitiven Element 6 innerhalb der Vorrichtung 2 in zwei verschiedenen räumlichen Ausrichtungen des magnetosensitiven Elements 4 mit einer um einen Abstand 54 axial verschobenen (4a,4c) und einer zentralen Jochposition (4b,4d) dargestellt, wobei alle Elemente stark vereinfacht und in einer Schnittdarstellung gezeigt sind.

Zum Erzielen von robusten Messergebnissen ist in einer unmittelbaren Nähe des magnetosensitiven Elements 6 ein Flussdichteminimum wünschenswert. Um dies zu erreichen, ist das magnetosensitive Element 6 in einem Magnetelement 55 angeordnet vorgesehen. Das Magnetelement 55 ist einteilig ausgeführt, weist einen Grundkörper 56 und Vorsprünge 57,58 und 59 auf, welche sich vom Grundkörper 56 aus in Richtung Kolbenachse 29 erstrecken. Dabei ist der mittlere Vorsprung 58 kürzer ausgebildet, als die ihn flankierenden gleichlangen Vorsprünge 57 und 59. An ihren der die Kolbenachse 29 zugewandten Enden weisen die Vorsprünge 57,58 und 59 gleichgerichtete Magnetpole 60,61 und 62 auf. Dadurch werden um das magnetosensitive Element 6 symbolisch dargestellte Magnetfelder 16 und 63 gebildet. Dabei wird das Magnetfeld 16 von dem Magnetfeld 63 abgestoßen und dadurch in Richtung Kolbenachse 29 gedrückt. Wie aus der Fig.4a ersichtlich, erstreckt sich das Magnetfeld 16 weitgehend oberhalb des magnetosensitiven Elements 6 und zwar derart, dass ein das magnetosensitive Element 6 zumindest teilweise einschließender Raumabschnitt lokalisierbar ist, in welchem ein Wert einer magnetischen Flussdichte gleich oder nahezu gleich 0mT beträgt. Ein solcher Raumabschnitt wird fortan als Arbeitsbereich 26 bezeichnet und ist insbesondere dafür verantwortlich, dass auch kleinste Änderungen der Flussdichte effektiv und sicher vom magnetosensitiven Element 6 registriert werden können.

Das Joch 4 wird bei einer Kolbenbewegung entlang einer Bewegungsachse 51 parallel zur Kolbenachse 29 um einen axialen Abstand 54 quer zum magnetosensitiven Element 6 verschoben. Aus der Fig.4b ist ersichtlich, dass das Magnetfeld 16 dabei durch das Joch 4 verzerrt und in den Arbeitsbereich 26 hineingedrängt wird. Diese Beeinflussung des Magnetfeldes 16 verursacht eine lokale Veränderung einer Magnetflussdichte innerhalb des magnetosensitiven Elements 6. In einem als ein Hall-Element ausgeführten magnetosensitiven Element 6 erzeugt diese Flussdichteänderung eine Veränderung einer abgreifbaren in der Fig.3 gezeigten elektrischen Spannung 49 "U". Durch eine Auswertung des Wertes der elektrischen Spannung 49 kann, ausgehend von einem in einer ersten Position des Jochs 4 erfassten Wertes, ein Umfang einer Verschiebung des Jochs 4 gegenüber seiner ersten Position und damit beispielsweise eine neue momentane Position eines mit dem Joch 4 verbundenen Kolbens berechnet werden.

In den Fig.4a und 4b ist das magnetosensitive Element 6 derart angeordnet, dass eine Normale 20 seiner sensitiven Ebene 50 parallel zur Bewegungsachse 51 liegt. Fig4c und 4d zeigen eine weitere geeignete Ausführungsform, bei die Normale 20 der sensitiven Ebene 50 des magnetosensitiven Elements 6 senkrecht zur Bewegungsachse 51 ausgerichtet ist. Ferner ist aus der Fig.4 ersichtlich, dass die beiden gezeigten Anordnungen prinzipiell gleich funktionieren. Eine Auswahl einer passenden Ausführungsform bzw. einer Ausrichtung des magnetosensitiven Elements 6 relativ zur Bewegungsachse 51 für einen konkreten Einsatzfall kann dabei durch jeweilige Vorgaben wie Bauraum, einen gewünschten Überwachungsbereich und Messgenauigkeit, jeweiligen spezifischen Eigenschaften eines magnetosensitive Elements 4 und des Jochs 4 und weitere Faktoren beeinflusst werden.

Ferner können in weiteren Weiterbildungen der Erfindung mehrere magnetosensitive Elemente 6 nebeneinander in einer Sensoreinheit 5 angeordnet werden. Durch eine solche Anordnung von zwei gleichen magnetosensitiven Elementen kann beispielsweise eine Redundanz und dadurch eine erhöhte Ausfallsicherheit und Zuverlässigkeit der Messergebnisse erreicht werden. Es kann jedoch ebenso ein digitales und ein analoges magnetosensitives Element nebeneinander vorgesehen werden um einen Funktionsumfang der Vorrichtung 2 zu erweitern, eine kostengünstige Backuplösung mit einem begrenzten Funktionsumfang zu realisieren oder ein anderes erwünschtes Ergebnis zu erzielen.

### Fig.5

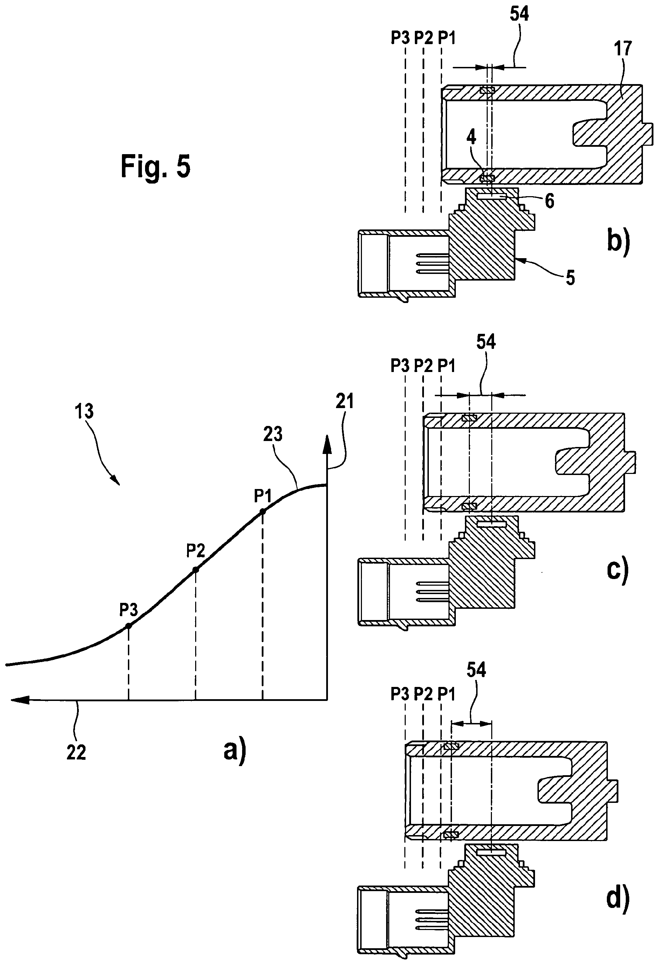

In einer in der Fig.5a dargestellten Diagramm 13 ist durch eine Kurve 23 beispielhaft und nicht maßstäblich ein prinzipieller Verlauf einer durch das magnetosensitive Element 6 registrierten magnetischen Flussdichte über einen Weg des Kolbens 17 bzw. des Jochs 4 aufgezeigt. Auf einer senkrechten Achse 21 des Diagramms ist dabei eine Intensität der Flussdichte, und auf einer waagerechten Achse 22 ein Weg, bzw. ein Verschiebemaß des Jochs 4 aufgetragen. Punkte P1, P2 und P3 entsprechen dabei prinzipiell den verschiedenen Positionen beziehungsweise axialen Abständen 54 des Kolbens 17 relativ zur Sensoreinheit 5 wie in den Fig.5b,5c und 5d verdeutlicht ist. Es ist ersichtlich, dass zwischen den Punkten P1 und P3 ein nahezu linearer Verlauf der Kurve 23 vorliegt. Dadurch ist eine Position des Jochs 4 besonders einfach und zuverlässig interpretierbar, auch eine Fehlererkennung wird deutlich vereinfacht und ein Toleranzeinfluss wird verringert.

Position P1 kann beispielsweise als eine Ausgangslage des Kolbens 17 in einem unbetätigten Zustand eines Hauptbremszylinders, in welcher der Kolben angeordnet ist, vorgesehen werden. Unter Bezugnahme der Fig.4 wird ersichtlich, dass in dieser Kolbenposition (5b) das Joch 4 nahezu direkt über dem magnetosensitiven Element 6 positioniert ist und es ist eine nahezu maximal mögliche Flussdichte registrierbar (vergleiche Fig.4d). Bei einer Verschiebung des Kolbens 17 in die Position P2 (5c) verschiebt sich das Joch 4 relativ zum magnetosensitiven Element 6 , das Magnetfeld entzerrt sich teilweise , der Arbeitsbereich 26 wird nun in einem geringeren Maße durchdrungen als bei Position P1 und ein registrierbarer Wert der Flussdichte verringert sich. Diese Entwicklung setzt sich bei Position des Kolbens 17 P3 fort, so dass im Arbeitsbereich 26 nun nahezu ein minimal möglicher Wert der Flussdichte registrierbar wird (vergleiche Fig.4c).

### Fig. 6

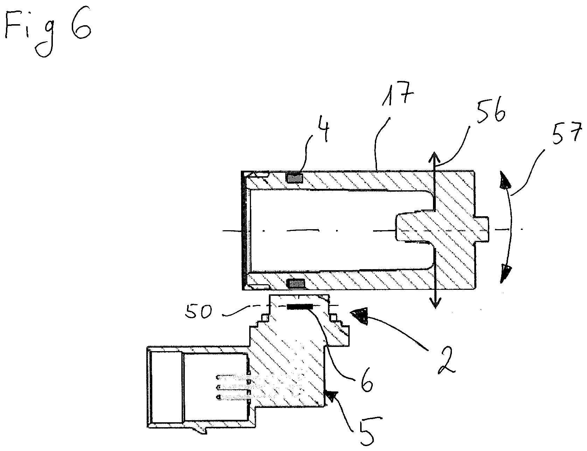

Jedes technisches Erzeugnis ist toleranzbehaftet. Ein Verlauf wie in der Diagramm 13 gezeigt, stellt einen Idealfall dar. In der Fig.6 ist prinzipiell verdeutlicht, dass beispielsweise ein relativer Abstand zwischen der Sensoreinheit 5 und dem Kolben 17 in Querrichtung 24 variieren, eine relative Winkligkeit 25 der Bewegungsachse 51 zur sensitiven Ebene 50 von einer konstruktiv festgelegten Vorgabe abweichen und auch weitere, hier nicht explizit gezeigte Form- und Lagetoleranzen auftreten.

Diese und weitere Toleranzen können einen relativen Abstand des Jochs 4 zum magnetosensitiven Element 6 und somit das Messergebnis unerwünscht beeinflussen. Es erscheint daher sinnvoll, eine elektronische Kalibrierung der Vorrichtung 2 vorzunehmen, um eine tatsächliche räumliche Lage der betroffenen Elemente zueinander den tatsächlich gemessenen Werten der Flussdichte zuzuordnen, beispielsweise eine tatsächlich Ausgangslage des Kolbens 17 im Bremshauptzylinder 3(Fig.2) in einem unbetätigten Zustand der Hauptbremszylinder 1 einem dabei errechneten Wert der magnetischen Flussdichte im magnetosensitiven Element 6. Dieser Wert kann dann beispielsweise jedes Mal nach einem Zündungsvorgang in einem Kraftfahrzeug bestimmt und der Position P1 (siehe Fig.5) neu zugeordnet werden. Es kann jedoch bei bestimmten Anforderungen ebenso auf eine solche Maßnahme verzichtet werden oder ein toleranzausgleich auf eine andere Weise oder in einem anderem Rhythmus durchgeführt werden.

### Fig.7

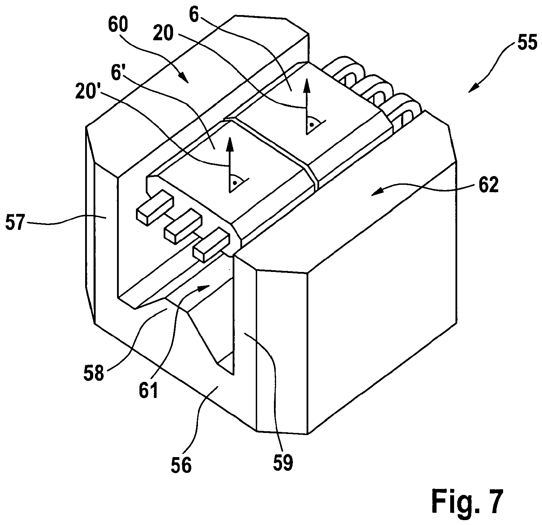

In der Fig.7 ist eine Ausführungsform eines Magnetelements 55 mit zwei darin angeordneten magnetosensitiven Elementen 6,6' in einer räumlichen Darstellung abgebildet. Die magnetosensitiven Elemente 6,6' sind nebeneinander in einem Raumabschnitt positioniert, welcher durch den Magnetpol 60 am Ende des Vorsprungs 57, den Magnetpol 62 am Ende des gleichlangen Vorsprungs 59 und dem Magnetpol 61 am Ende des kürzeren Vorsprungs 58 begrenzt ist. In der hier abgebildeten Ausführungsform entspricht die Ausrichtung der Normalen 20,20' einer in der Fig.4c,d gezeigten Anordnung. Es versteht sich, dass in weiteren Ausführungsformen sowohl anders ausgerichtete Anordnungen der magnetosensitiven Elemente 6,6', beispielsweise nach Fig.4a,b, als auch andere Anzahl von magnetosensitiven Elementen innerhalb des Magnetelements 55, beispielsweise ein einzelnes Element, innerhalb der Erfindung möglich sind.

### Bezugszeichen:

- 1: Hauptbremszylinder
- 2: Vorrichtung
- 3: Gehäuse
- 4: Joch
- 5: Sensoreinheit
- 6, 6': Magnetosensitives Element
- 7: Elektronische Auswerteeinheit
- 8: Anschluss
- 9: Anschluss
- 10: Druckstange
- 11: Betätigungskraft
- 12: Flansch
- 13: Diagramm
- 14: Normale
- 15: Verbindungselement
- 16: Magnetfeld
- 17: Kolben
- 18: Trennbare elektrische Verbindung
- 19: Elektrische Leitung
- 20: Normale
- 21: Achse
- 22: Achse
- 23: Kurve
- 24: Querrichtung
- 25: Winkligkeit
- 26: Arbeitsbereich
- 27: Kolben
- 28: Hohlraum
- 29: Kolbenachse
- 30: Dichtelement
- 31: Dichtelement
- 32: Dichtelement
- 33: Dichtelement
- 34: Druckraum
- 35: Druckraum
- 36: Nachlaufbohrung
- 37: Nachlaufbohrung
- 38: Niederdruckbereich
- 39: Niederdruckbereich
- 40: Rückstellfeder
- 41: Rückstellfeder
- 42: Kontaktierelement
- 43: Hall-Element
- 44: Stromfluss
- 45: Festkörper
- 46: Magnetfeld
- 47: Lorentz-Kraft
- 48,: 48' Seite
- 49: Spannung
- 50,: 50' Sensitive Ebene
- 51: Bewegungsachse
- 52: Ausnehmung
- 53: Koordinatensystem
- 54: Abstand
- 55: Magnetelement
- 56: Grundkörper
- 57: Vorsprung
- 58: Vorsprung
- 59: Vorsprung
- 60: Magnetpol
- 61: Magnetpol
- 62: Magnetpol
- 63: Magnetfeld
- 64: Signalverarbeitungsvorrichtung

## Patentansprüche

1. Hauptbremszylinder (1), zur Verwendung innerhalb eines elektronischen Bremssystems für Kraftfahrzeuge, mit einer Vorrichtung (2) zur berührungslosen Überwachung einer Position eines entlang einer Kolbenachse (29) linear bewegbaren Kolbens (17), wobei die Vorrichtung (2) ein bewegbares Element und eine Sensoreinheit (5) beinhaltet, und wobei die Sensoreinheit (5) an einem Gehäuse (3) vom Hauptbremszylinder (1) ortsfest angeordnet und mit einer elektronischen Auswerteeinheit (7) zur Verarbeitung von Signalen der Vorrichtung (2) verbunden ist, **dadurch gekennzeichnet, dass** ein Magnetfeld (16) von einem Magnetelement (55) in der Sensoreinheit (5) ausgesendet wird, wobei das Magnetelement (55) einteilig gestaltet ist, einen Grundkörper (56) aufweist und wobei wenigstens drei Vorsprünge (57,58,59) vom Grundkörper (56) weitgehend in Richtung Kolbenachse (29) ausgebildet sind und wobei die Vorsprünge (57,58,59) an ihren, der Kolbenachse (29) zugewandten, Enden Magnetpole (60,61,62) aufweisen und dass dem Kolben (17) ein Joch (4) zur positionsabhängigen Veränderung von dem Magnetfeld (16) derart zugeordnet ist, dass diese Veränderung von der Sensoreinheit (5) erfassbar ist.

2. Hauptbremszylinder (1) nach Anspruch 1 **dadurch gekennzeichnet, dass** wenigstens ein Vorsprung (58) kürzer als wenigstens zwei weitere Vorsprünge (57,59) ausgebildet ist.

3. Hauptbremszylinder (1) nach wenigstens einem der vorstehenden Ansprüche **dadurch gekennzeichnet, dass** der Kolben (17) aus einem nicht magnetisierbaren Werkstoff, wie insbesondere einem Kunststoffwerkstoff, ausgebildet ist.

4. Hauptbremszylinder (1) nach wenigstens einem der vorstehenden Ansprüche **dadurch gekennzeichnet, dass** das Gehäuse (3) aus einem nicht magnetisierbaren Werkstoff, wie insbesondere Aluminiumwerkstoff oder Kunststoffwerkstoff, ausgebildet ist.

5. Hauptbremszylinder (1) nach wenigstens einem der vorstehenden Ansprüche **dadurch gekennzeichnet, dass** das Joch (4) mittelbar oder unmittelbar an dem Kolben (17) angeordnet vorgesehen ist.

6. Hauptbremszylinder (1) nach Anspruch 5, **dadurch gekennzeichnet, dass** das Joch (4) an dem Kolben (17) abgestützt oder an dem Kolben (17) fixiert ist.

7. Hauptbremszylinder (1) nach Anspruch 6, **dadurch gekennzeichnet, dass** der Kolben (17) wenigstens eine Ausnehmung (52) mit einer Aufnahme, wie insbesondere eine Nut, für das Joch (4) aufweist.

8. Hauptbremszylinder (1) nach Anspruch 6 oder 7 **dadurch gekennzeichnet, dass** das Joch (4) ringförmig ausgebildet und/oder in die Ausnehmung (52) eingefügt vorgesehen ist.

9. Hauptbremszylinder (1) nach wenigstens einem der vorstehenden Ansprüche **dadurch gekennzeichnet, dass** das Joch (4) einen Außenumfang aufweist, der von einem nicht magnetisierbaren Werkstoff, wie insbesondere einem Kunststoffwerkstoff bedeckt ist.

10. Hauptbremszylinder (1) nach wenigstens einem der vorstehenden Ansprüche **dadurch gekennzeichnet, dass** das Joch (4) aus einem Stahlwerkstoff ausgebildet ist.

11. Hauptbremszylinder (1) nach wenigstens einem der vorstehenden Ansprüche **dadurch gekennzeichnet, dass** durch die Sensoreinheit (5) eine Änderung von dem Magnetfeld (16) in einer Radialrichtung (R) erfassbar ist, die im Wesentlichen senkrecht zu einer Bewegungsachse (51) des Kolbens (17) angeordnet ist.

12. Hauptbremszylinder (1) nach wenigstens einem der vorstehenden Ansprüche **dadurch gekennzeichnet, dass** die Sensoreinheit (5) wenigstens ein magnetosensitives Element (6) aufweist.

13. Hauptbremszylinder (1) nach Ansprüchen1,2 und 12 **dadurch gekennzeichnet, dass** das magnetosensitive Element (6) in einem Raumabschnitt zwischen den Magnetpolen (60,61,62) angeordnet ist.

14. Hauptbremszylinder (1) nach wenigstens einem der Ansprüche 12 oder 13 **dadurch gekennzeichnet, dass** das magnetosensitive Element (6) als ein Hall-Element ausgebildet ist.

15. Hauptbremszylinder (1) nach wenigstens einem der Ansprüche 12 oder 13, **dadurch gekennzeichnet, dass** dem magnetosensitiven Element (6) zusätzlich wenigstens eine elektronische Signalverarbeitungsvorrichtung (64) zugeordnet ist, die in der Sensoreinheit (5) integriert vorgesehen ist.

16. Hauptbremszylinder (1) nach wenigstens einem der vorstehenden Ansprüche **dadurch gekennzeichnet, dass** das Joch (4) in einem Niederdruckbereich (38) des Hauptbremszylinders (1) außerhalb von den Druckräumen (34,35) angeordnet ist.

17. Verfahren zum Erfassen einer Kolbenverschiebung in einem Hauptbremszylinder (1) nach den Merkmalen vom Anspruch 1 **dadurch gekennzeichnet, dass** die Sensoreinheit (5) ein Magnetfeld (16) in Richtung Kolben (17) aussendet, und wobei dem Kolben (17) ein Joch (4) zur positionsabhängigen Veränderung vom Magnetfeld (16) derart zugeordnet ist, dass die Veränderung durch die Sensoreinheit (5) erfasst wird, und wobei elektrische Signale der Sensoreinheit (5) von der elektronischen Auswerteeinheit (7) ausgewertet werden.

18. Verfahren nach Anspruch 17, **dadurch gekennzeichnet, dass** zumindest nach einem Zusammenbau von dem Hauptbremszylinder (1) ein Kalibriervorgang derart vorgesehen ist, dass in der Auswerteeinheit (7) oder in der Sensoreinheit (5) ein axialer Abstand (54) zwischen Joch (4) und der Sensoreinheit (5) zur Markierung von einer unbetätigten Ausgangslage von dem Kolben (17) abgespeichert wird.

19. Verfahren nach Anspruch 18, **dadurch gekennzeichnet, dass** der Kalibriervorgang wiederholt, insbesondere periodisch und/oder bei jeder Betätigung von dem Hauptbremszylinder (1) ausgeführt wird.

20. Verfahren nach Anspruch 18 oder 19, **dadurch gekennzeichnet, dass** zumindest jedem Kalibriervorgang, vorzugsweise jedem Messvorgang, Temperaturdaten derart zugeordnet sind, dass es ermöglicht ist, temperaturbedingte Auswirkungen auf eine oder mehrere Systemkomponenten oder elektrischen Signale elektronisch zu kompensieren.

## Claims

1. Brake master cylinder (1), for use within an electronic brake system for motor vehicles, having an apparatus (2) for contactlessly monitoring a position of a piston (17) which can be moved linearly along a piston axis (29), the apparatus (2) containing a movable element and a sensor unit (5), and the sensor unit (5) being arranged in a stationary manner on a housing (3) of the brake master cylinder (1) and being connected to an electronic evaluation unit (7) for processing signals of the apparatus (2), **characterized in that** a magnetic field (16) is emitted by a magnet element (55) in the sensor unit (5), the magnet element (55) being of single-piece design, having a main body (56), and at least three projections (57, 58, 59) being formed by the main body (56) largely in the direction of the piston axis (29), and the projections (57, 58, 59) having magnetic poles (60, 61, 62) at their ends which face the piston axis (29), and **in that** the piston (17) is assigned a yoke (4) for changing the magnetic field (16) in a position-dependent manner in such a way that this change can be detected by the sensor unit (5).

2. Brake master cylinder (1) according to Claim 1, **characterized in that** at least one projection (58) is configured so as to be shorter than at least two further projections (57, 59).

3. Brake master cylinder (1) according to at least one of the preceding claims, **characterized in that** the piston (17) is configured from a non-magnetizable material, such as, in particular, a plastic material.

4. Brake master cylinder (1) according to at least one of the preceding claims, **characterized in that** the housing (3) is configured from a non-magnetizable material, such as, in particular, aluminum material or plastic material.

5. Brake master cylinder (1) according to at least one of the preceding claims, **characterized in that** the yoke (4) is provided such that it is arranged indirectly or directly on the piston (17).

6. Brake master cylinder (1) according to Claim 5, **characterized in that** the yoke (4) is supported on the piston (17) or is fixed on the piston (17).

7. Brake master cylinder (1) according to Claim 6, **characterized in that** the piston (17) has at least one recess (52) with a receptacle, such as, in particular, a groove, for the yoke (4).

8. Brake master cylinder (1) according to Claim 6 or 7, **characterized in that** the yoke (4) is provided such that it is of annular configuration and/or is inserted into the recess (52).

9. Brake master cylinder (1) according to at least one of the preceding claims, **characterized in that** the yoke (4) has an outer circumference which is covered by a non-magnetizable material, such as, in particular, a plastic material.

10. Brake master cylinder (1) according to at least one of the preceding claims, **characterized in that** the yoke (4) is configured from a steel material.

11. Brake master cylinder (1) according to at least one of the preceding claims, **characterized in that** a change of the magnetic field (16) in a radial direction (R) can be detected by way of the sensor unit (5), which radial direction (R) is arranged substantially perpendicularly with respect to a movement axis (51) of the piston (17).

12. Brake master cylinder (1) according to at least one of the preceding claims, **characterized in that** the sensor unit (5) has at least one magneto-sensitive element (6).

13. Brake master cylinder (1) according to Claims 1, 2 and 12, **characterized in that** the magneto-sensitive element (6) is arranged in a spatial section between the magnetic poles (60, 61, 62).

14. Brake master cylinder (1) according to at least one of Claims 12 and 13, **characterized in that** the magneto-sensitive element (6) is configured as a Hall element.

15. Brake master cylinder (1) according to at least one of Claims 12 and 13, **characterized in that** the magneto-sensitive element (6) is additionally assigned at least one electronic signal processing apparatus (64) which is provided such that it is integrated into the sensor unit (5) .

16. Brake master cylinder (1) according to at least one of the preceding claims, **characterized in that** the yoke (4) is arranged in a low pressure region (38) of the brake master cylinder (1) outside the pressure spaces (34, 35).

17. Method for detecting a piston displacement in a brake master cylinder (1) in accordance with the features of Claim 1, **characterized in that** the sensor unit (5) emits a magnetic field (16) in the direction of the piston (17), and the piston (17) being assigned a yoke (4) for changing the magnetic field (16) in a position-dependent manner in such a way that the change is detected by the sensor unit (5), and electrical signals of the sensor unit (5) being evaluated by the electronic evaluation unit (7).

18. Method according to Claim 17, **characterized in that**, at least after the brake master cylinder (1) is assembled, a calibrating operation is provided in such a way that an axial spacing (54) between the yoke (4) and the sensor unit (5) is stored in the evaluation unit (7) or in the sensor unit (5) in order to mark a non-actuated starting position of the piston (17).

19. Method according to Claim 18, **characterized in that** the calibrating operation is carried out repeatedly, in particular periodically and/or upon each actuation of the brake master cylinder (1).

20. Method according to Claim 18 or 19, **characterized in that** at least each calibrating operation, preferably each measuring operation, is assigned temperature data in such a way that it is made possible to compensate electronically for temperature-induced effects on one or more system components or electrical signals.

## Revendications

1. Maître-cylindre de frein (1), destiné à être utilisé à l'intérieur d'un système de freinage électronique pour des véhicules automobiles, comportant un dispositif (2) qui permet une surveillance sans contact d'une position d'un piston (17) mobile linéairement le long d'un axe (29) du piston, dans lequel le dispositif (2) contient un élément mobile et une unité de détection (5), et dans lequel l'unité de détection (5) est montée de manière stationnaire sur un boîtier (3) du maître-cylindre de frein (1) et est reliée à une unité d'analyse (7) électronique pour le traitement de signaux du dispositif (2),
**caractérisé en ce qu'**un champ magnétique (16) est émis par un élément magnétique (55) dans l'unité de détection (5), dans lequel l'élément magnétique (55) est conçu en une seule pièce et comporte un corps de base (56), et dans lequel au moins trois protubérances (57, 58, 59) sont réalisées à partir du corps de base (56) principalement dans la direction de l'axe (29) du piston et dans lequel les protubérances (57, 58, 59) présentent des pôles magnétiques (60, 61, 62) à leurs extrémités orientées vers l'axe (29) du piston, et **en ce qu'**une culasse (4) est associée au piston (17) pour modifier le champ magnétique (16) en fonction de la position, de telle manière que cette modification puisse être détectée par l'unité de détection (5).

2. Maître-cylindre de frein (1) selon la revendication 1, **caractérisé en ce qu'**au moins une protubérance (58) est conçue pour être plus courte qu'au moins deux autres protubérances (57, 59).

3. Maître-cylindre de frein (1) selon au moins l'une des revendications précédentes, **caractérisé en ce que** le piston (17) est réalisé en un matériau non magnétisable, notamment tel qu'une matière plastique.

4. Maître-cylindre de frein (1) selon au moins l'une des revendications précédentes, **caractérisé en ce que** le boîtier (3) est réalisé en un matériau non magnétisable, notamment tel qu'un matériau d'aluminium ou une matière plastique.

5. Maître-cylindre de frein (1) selon au moins l'une des revendications précédentes, **caractérisé en ce que** la culasse (4) est prévue indirectement ou directement sur le piston (17).

6. Maître-cylindre de frein (1) selon la revendication 5, **caractérisé en ce que** la culasse (4) est supportée sur le piston (17) ou fixée au piston (17).

7. Maître-cylindre de frein (1) selon la revendication 6, **caractérisé en ce que** le piston (17) présente au moins un évidement (52) qui comporte un logement, en particulier une rainure, pour la culasse (4) .

8. Maître-cylindre de frein (1) selon la revendication 6 ou 7, **caractérisé en ce que** la culasse (4) est réalisée sous forme annulaire et/ou est prévue de manière insérée dans l'évidement (52).

9. Maître-cylindre de frein (1) selon au moins l'une des revendications précédentes, **caractérisé en ce que** la culasse (4) présente une circonférence extérieure qui est recouverte d'un matériau non magnétisable, notamment tel qu'une matière plastique.

10. Maître-cylindre de frein (1) selon au moins l'une des revendications précédentes, **caractérisé en ce que** la culasse (4) est réalisée en acier.

11. Maître-cylindre de frein (1) selon au moins l'une des revendications précédentes, **caractérisé en ce qu'**une modification du champ magnétique (16) dans une direction radiale (R) qui est orientée sensiblement perpendiculairement à un axe de mouvement (51) du piston (17) peut être détectée par l'unité de détection (5).

12. Maître-cylindre de frein (1) selon au moins l'une des revendications précédentes, **caractérisé en ce que** l'unité de détection (5) comporte au moins un élément magnétosensible (6).

13. Maître-cylindre de frein (1) selon les revendications 1, 2 et 12, **caractérisé en ce que** l'élément magnétosensible (6) est disposé dans un espace compris entre les pôles magnétiques (60, 61, 62).

14. Maître-cylindre de frein (1) selon au moins l'une des revendications 12 ou 13, **caractérisé en ce que** l'élément magnétosensible (6) est réalisé sous forme d'élément Hall.

15. Maître-cylindre de frein (1) selon au moins l'une des revendications 12 ou 13, **caractérisé en ce que** l'élément magnétosensible (6) est en outre associé à au moins un dispositif électronique de traitement de signaux (64) qui est prévu de manière intégrée à l'unité de détection (5).

16. Maître-cylindre de frein (1) selon au moins l'une des revendications précédentes, **caractérisé en ce que** la culasse (4) est disposée dans une zone à basse pression (38) du maître-cylindre de frein (1) à l'extérieur des chambres à pression (34,35).

17. Procédé de détection d'un déplacement de piston dans un maître-cylindre de frein (1) selon les caractéristiques de la revendication 1, **caractérisé en ce que** l'unité de détection (5) émet un champ magnétique (16) dans la direction du piston (17),
et dans lequel une culasse (4) est associée au piston (17) pour modifier le champ magnétique (16) en fonction de la position, de telle manière que la modification soit détectée par l'unité de détection (5), et dans lequel des signaux électriques de l'unité de détection (5) sont analysés par l'unité d'analyse (7) électronique.

18. Procédé selon la revendication 17, **caractérisé en ce qu'**au moins après le montage du maître-cylindre de frein (1), un processus d'étalonnage est prévu de telle manière qu'une distance axiale (54) entre la culasse (4) et l'unité de détection (5) soit stockée dans l'unité de traitement (7) ou dans l'unité de détection (5) pour marquer une position initiale non actionnée du piston (17) .

19. Procédé selon la revendication 18, **caractérisé en ce que** le processus d'étalonnage est répété, notamment périodiquement et/ou à chaque actionnement du maître-cylindre de frein (1).

20. Procédé selon la revendication 18 ou 19, **caractérisé en ce que** des données de température sont associées à au moins chaque processus d'étalonnage, de préférence à chaque processus de mesure, de telle manière qu'il soit possible de compenser de manière électronique des effets liés à la température sur un ou plusieurs composants système ou signaux électriques.
